(19) Europäisches Patentamt / European Patent Office / Office européen des brevets

(11) **EP 4 396 595 B1**

(12) **EUROPÄISCHE PATENTSCHRIFT**

(45) Veröffentlichungstag und Bekanntmachung des Hinweises auf die Patenterteilung:
**05.08.2026   Patentblatt 2026/32**

(21) Anmeldenummer: **22731223.8**

(22) Anmeldetag: **01.06.2022**

(51) Internationale Patentklassifikation (IPC):
**G01R 31/396** (2019.01)    **G01R 31/3828** (2019.01)

(52) Gemeinsame Patentklassifikation (CPC):
**G01R 31/396; G01R 31/3828;** G01R 31/367

(86) Internationale Anmeldenummer:
**PCT/EP2022/064879**

(87) Internationale Veröffentlichungsnummer:
**WO 2023/030708 (09.03.2023 Gazette 2023/10)**

(54) **VERFAHREN ZUR BESTIMMUNG EINES LADEZUSTANDS EINES ELEKTRISCHEN ENERGIESPEICHERS, ELEKTRISCHER ENERGIESPEICHER UND VORRICHTUNG**

METHOD FOR DETERMINING A STATE OF CHARGE OF AN ELECTRIC ENERGY STORE, ELECTRIC ENERGY STORE, AND DEVICE

PROCÉDÉ DESTINÉ À LA DÉTERMINATION D'UN ÉTAT DE CHARGE D'UN ACCUMULATEUR D'ÉNERGIE ÉLECTRIQUE, ACCUMULATEUR D'ÉNERGIE ÉLECTRIQUE ET DISPOSITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.08.2021   DE 102021209542**

(43) Veröffentlichungstag der Anmeldung:
**10.07.2024   Patentblatt 2024/28**

(73) Patentinhaber: **Robert Bosch GmbH**
**70442 Stuttgart (DE)**

(72) Erfinder:
• **KOHN, Peter**
  **70469 Stuttgart (DE)**
• **SCHARFF, Vincent**
  **70439 Stuttgart (DE)**
• **NIPPER, Johannes Maximilian**
  **70435 Stuttgart (DE)**
• **SUSMITHA, Ganesh**
  **Bengaluru 560043 (IN)**
• **DESAI, Venkatrao**
  **Kalaburagi, Karnataka 585102 (IN)**
• **SARFERT, Christel**
  **70825 Korntal-Muenchingen (DE)**
• **ZAFIRIDIS, Triantafyllos**
  **74074 Heilbronn (DE)**
• **SWOBODA, Johannes**
  **70176 Stuttgart (DE)**
• **SHASHANK, Holavanahalli**
  **70565 Stuttgart (DE)**
• **COIS, Olivier**
  **71394 Kernen (DE)**
• **KROENER, Christoph**
  **71691 Freiberg am Neckar (DE)**
• **SCHNEIDER, Joerg**
  **71640 Ludwigsburg (DE)**

(56) Entgegenhaltungen:
EP-A1- 2 787 361       EP-A1- 3 650 265
WO-A1-2015/132544    GB-A- 2 478 557
US-A1- 2021 190 867

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Feld der Erfindung

Die vorliegende Erfindung bezieht sich auf ein Verfahren zur Bestimmung eines Ladezustands eines elektrischen Energiespeichers, einen elektrischen Energiespeicher und eine Vorrichtung.

Stand der Technik

Die US 2010/0321025 A1 offenbart ein Verfahren zur Verwendung mit einem Fahrzeugbatteriestapel, der eine Anzahl einzelner Batteriezellen aufweist.

Die US 2007/0299620 A1 zeigt ein Verfahren zur Bestimmung des Ladezustands einer Batterie, ein Batteriemanagementsystem, das dieses verwendet und ein Betriebsverfahren hierfür.

Die US 2014/0333317 A1 offenbart einen Batteriezustandsschätzer, der ein elektrochemisches Festkörperkonzentrationsmodell mit einem empirischen Ersatzschaltungsmodell kombiniert.

Die GB 2 478 557 A offenbart ein Verfahren zur Berechnung des Ladezustands einer Batterie, indem Strom und/oder Spannung gemessen werden, um einen Wertebereich zu erhalten, der zur Berechnung von SOC-Wertebereichen in mindestens zwei verschiedenen Schätzverfahren genutzt wird.

Die EP 2 787 361 A1 offenbart ein Batteriepack, bei dem wiederholt der Ladezustand einer Zelle, die abwechselnd Lade-/Entladezustände einnimmt, mittels Stromintegration und Leerlaufspannungsmessung ermittelt wird.

Die US 2021/190867 A1 offenbart ein System zur Leistungsschätzung für ein Elektrofahrzeug, welche den internen Zustand eines Energiespeichers schätzt.

Offenbarung der Erfindung

Der Kern der Erfindung bei dem Verfahren zur Bestimmung eines Ladezustands eines elektrischen Energiespeichers aufweisend elektrische Energiespeicherzellen und zumindest einen Sensor, besteht darin, dass in einem ersten Verfahrensschritt Betriebsparameter des elektrischen Energiespeichers bestimmt werden, wobei in einem zweiten Verfahrensschritt zumindest ein maximaler Ladezustand und zumindest ein minimaler Ladezustand für jede elektrische Energiespeicherzelle als zeitliches Integral bestimmt werden basierend auf einem Strom, einer Strommessungenauigkeit, zumindest einer Kapazität, einem Korrekturwert für den minimalen Ladezustand und einem Korrekturwert für den maximalen Ladezustand der elektrischen Energiespeicherzellen, wobei der Korrekturwert für den minimalen Ladezustand mittels eines minimalen Ladezustands auf Basis einer gefilterten minimalen Leerlaufspannung des elektrischen Energiespeichers bestimmt wird, wobei der Korrekturwert für den maximalen Ladezustand mittels eines maximalen Ladezustands auf Basis einer gefilterten maximalen Leerlaufspannung des elektrischen Energiespeichers bestimmt wird, wobei ein maximaler Ladezustand des elektrischen Energiespeichers das Maximum der maximalen Ladezustände aller elektrischen Energiespeicherzellen ist und ein minimaler Ladezustand des elektrischen Energiespeichers das Minimum der minimalen Ladezustände aller elektrischen Energiespeicherzellen ist.

Hintergrund der Erfindung ist, dass bei der Bestimmung des Ladezustands während des Betriebs des elektrischen Energiespeichers mittels Stromintegration vor allem bei längerer Betriebsdauer große Abweichungen aufgrund von Messfehlern auftreten können. Mittels des erfindungsgemäßen Verfahrens werden diese Abweichungen reduziert, so dass eine genaue Abschätzung des Ladezustands ermöglicht wird. Somit lässt sich beispielsweise die verbleibende Reichweite eines elektrisch angetriebenen Fahrzeugs genauer abschätzen oder die verbleibende Anzahl der Startvorgänge eines Verbrennungsmotors lässt sich genauer abschätzen.

Vorteilhafterweise liegt der gemittelte aktuelle Ladezustand des elektrischen Energiespeichers während des Betriebs des elektrischen Energiespeichers in einem Intervall zwischen dem minimalen Ladezustand und dem maximalen Ladezustand des elektrischen Energiespeichers.

Weitere vorteilhafte Ausführungsformen der vorliegenden Erfindung sind Gegenstand der Unteransprüche.

Gemäß einer vorteilhaften Ausgestaltung werden im zweiten Verfahrensschritt für jede elektrische Energiespeicherzelle jeweils zwei minimale Ladezustände und zwei maximale Ladezustände bestimmt, insbesondere wobei zur Bestimmung von ersten maximalen Ladezuständen eine Kapazität am Anfang der Lebensdauer der elektrischen Energiespeicherzellen verwendet wird und zur Bestimmung von zweiten maximalen Ladezuständen eine Kapazität am Ende der Lebensdauer der elektrischen Energiespeicherzellen verwendet wird, und wobei zur Bestimmung von ersten minimalen Ladezuständen die Kapazität am Anfang der Lebensdauer der elektrischen Energiespeicherzellen verwendet wird und zur Bestimmung von zweiten minimalen Ladezuständen die Kapazität am Ende der Lebensdauer der elektrischen Energiespeicherzellen verwendet wird. Dadurch ist die Genauigkeit bei der Bestimmung des Ladezustands des elektrischen Energiespeichers weiter verbessert.

Dabei ist es von Vorteil, wenn im zweiten Verfahrensschritt zur Bestimmung der maximalen Ladezustände jeder elektrischen Energiespeicherzelle die Summe aus Strommessungenauigkeit und Strom mit der reziproken Kapazität jeder elektrischen Energiespeicherzelle zu Beginn ihrer Lebensdauer multipliziert wird beziehungsweise mit der reziproken Kapazität jeder elektrischen Energiespeicherzelle am Ende ihrer Lebensdauer multipliziert wird und dazu jeweils der Korrekturwert für den maximalen Ladezustand addiert wird, wobei zur Bestimmung der minimalen Ladezustände jeder elektrischen Energiespeicherzelle die Differenz aus Strom und Strommessungenauigkeit mit der reziproken Kapazität jeder elektrischen Energiespeicherzelle zu Beginn ihrer Lebensdauer multipliziert beziehungsweise mit der reziproken Kapazität jeder elektrischen Energiespeicherzelle am Ende ihrer Lebensdauer multipliziert wird und dazu jeweils der Korrekturwert für den minimalen Ladezustand addiert wird. Mittels der Kapazitäten zu Beginn und am Ende der Lebensdauer der elektrischen Energiespeicherzellen sind Grenzwerte für die minimalen und maximalen Ladezustände der elektrischen Energiespeicherzellen während der Lebensdauer abschätzbar.

Weiterhin ist es von Vorteil, wenn in einem dritten Verfahrensschritt der maximale Ladezustand auf Basis der gefilterten maximalen Leerlaufspannung der elektrischen Energiespeicherzellen bestimmt wird und der minimale Ladezustand auf Basis der gefilterten minimalen Leerlaufspannung der elektrischen Energiespeicherzellen bestimmt wird, wobei in einem vierten Verfahrensschritt zur Bestimmung beziehungsweise Korrektur des Korrekturwerts für den maximalen Ladezustand die Differenz aus den maximalen Ladezuständen der elektrischen Energiespeicherzellen und dem maximalen Ladezustand auf Basis der gefilterten maximalen Leerlaufspannung der elektrischen Energiespeicherzellen gebildet wird und wobei zur Bestimmung beziehungsweise Korrektur des Korrekturwerts für den minimalen Ladezustand die Differenz aus den minimalen Ladezuständen der elektrischen Energiespeicherzellen und dem minimalen Ladezustand auf Basis der gefilterten minimalen Leerlaufspannung des elektrischen Energiespeichers gebildet wird. Dadurch lassen sich die Korrekturwerte mit hoher Genauigkeit bestimmen.

Vorteilhafterweise wird dabei ein elektrochemisches Batteriemodell verwendet.

Dabei ist es von Vorteil, wenn im vierten Verfahrensschritt zur Bestimmung beziehungsweise Korrektur des jeweiligen Korrekturwerts die Differenz aus den maximalen Ladezuständen der elektrischen Energiespeicherzellen und dem maximalen Ladezustand auf Basis der gefilterten maximalen Leerlaufspannung der elektrischen Energiespeicherzellen jeweils mit einem Korrekturfaktor multipliziert wird und die Differenz aus den minimalen Ladezuständen der elektrischen Energiespeicherzellen und dem minimalen Ladezustand auf Basis der gefilterten minimalen Leerlaufspannung des elektrischen Energiespeichers jeweils mit einem Korrekturfaktor multipliziert wird. Somit ist die Genauigkeit weiter verbessert.

Vorteilhafterweise wird zur Bestimmung der maximalen Leerlaufspannung der elektrischen Energiespeicherzellen eine Differenz aus dem Strom und der Strommessungenauigkeit gebildet und basierend auf der Temperatur des elektrischen Energiespeichers ein ohmscher Widerstand, ein Ladetransferwiderstand und ein Diffusionswiderstand zu Beginn der Lebensdauer der elektrischen Energiespeicherzelle bestimmt, wobei ein erstes Produkt aus der Summe aus dem ohmschen Widerstand und dem Ladetransferwiderstand und der Differenz aus dem Strom und der Strommessungenauigkeit gebildet wird, wobei der Diffusionswiderstand mit der Differenz aus dem Strom und der Strommessungenauigkeit multipliziert und anschließend von einem ersten Tiefpassfilter gefiltert und zu dem ersten Produkt addiert wird, wobei diese Summe für jede elektrische Energiespeicherzelle mit einer Summe aus der Zellspannung und der Zellspannungsmessungenauigkeit jeder elektrischen Energiespeicherzelle multipliziert wird und daraus mittels eines zweiten Tiefpassfilters die gefilterte maximale Leerlaufspannung der elektrischen Energiespeicherzellen bestimmt wird.

Weiterhin ist es von Vorteil, wenn zur Bestimmung der minimalen Leerlaufspannung der elektrischen Energiespeicherzellen eine Summe aus dem Strom und der Strommessungenauigkeit gebildet wird und basierend auf der Temperatur des elektrischen Energiespeichers ein ohmscher Widerstand, ein Ladetransferwiderstand und ein Diffusionswiderstand am Ende der Lebensdauer der elektrischen Energiespeicherzelle bestimmt wird, wobei ein zweites Produkt aus der Summe aus dem ohmschen Widerstand und dem Ladetransferwiderstand und der Summe aus dem Strom und der Strommessungenauigkeit gebildet wird, wobei der Diffusionswiderstand mit der Summe aus dem Strom und der Strommessungenauigkeit multipliziert und anschließend von einem dritten Tiefpassfilter gefiltert und zu dem zweiten Produkt addiert wird, wobei diese Summe für jede elektrische Energiespeicherzelle mit einer Differenz aus der Zellspannung und der Zellspannungsmessungenauigkeit jeder elektrischen Energiespeicherzelle multipliziert wird und daraus mittels eines vierten Tiefpassfilters die gefilterte maximale Leerlaufspannung der elektrischen Energiespeicherzellen bestimmt wird.

Vorteilhafterweise ist der maximale Ladezustand auf Basis der gefilterten maximalen Leerlaufspannung der elektrischen Energiespeicherzellen das Maximum aller Ladezustandskurven der elektrischen Energiespeicherzellen, und/oder der minimale Ladezustand auf Basis der gefilterten minimalen Leerlaufspannung der elektrischen Energiespeicherzellen ist das Minimum aller Ladezustandskurven der elektrischen Energiespeicherzellen. Dadurch werden alle elektrischen Energiespeicherzellen zur Bestimmung des maximalen beziehungsweise minimalen Ladezustands auf Basis der gefilterten Leerlaufspannungen berücksichtigt.

Weiterhin ist es von Vorteil, wenn der erste und/oder zweite Verfahrensschritt während des Betriebs des elektrischen Energiespeichers ausgeführt wird und/oder der dritte und/oder vierte Verfahrensschritt ausgeführt wird, wenn der elektrische Energiespeicher nicht in Betrieb ist. Von Vorteil ist dabei, dass während des Betriebs des elektrischen Energiespeichers der Ladezustand mit hoher Genauigkeit bestimmt werden kann. Nach dem Betrieb können der dritte und/oder vierte Verfahrensschritt ausgeführt werden, so dass die Korrekturwerte kontinuierlich angepasst und verbessert werden.

Der Kern der Erfindung bei dem elektrischen Energiespeicher besteht darin, dass ein Ladezustand des elektrischen Energiespeichers mittels eines Verfahrens wie zuvor beschrieben beziehungsweise nach einem der auf das Verfahren bezogenen Ansprüche durch den elektrischen Energiespeicher bestimmt wird.

Hintergrund der Erfindung ist, dass bei der Bestimmung des Ladezustands während des Betriebs des elektrischen Energiespeichers mittels Stromintegration vor allem bei längerer Betriebsdauer große Abweichungen aufgrund von Messfehlern auftreten können. Bei dem erfindungsgemäßen elektrischen Energiespeicher werden diese Abweichungen reduziert, so dass eine genaue Abschätzung des Ladezustands ermöglicht wird.

Der Kern der Erfindung bei der Vorrichtung, insbesondere Fahrzeug, besteht darin, dass die Vorrichtung einen elektrischen Energiespeicher wie zuvor beschrieben beziehungsweise nach einem der auf den elektrischen Energiespeicher bezogenen Ansprüche aufweist.

Hintergrund der Erfindung ist, dass sich die verbleibende Reichweite eines elektrisch angetriebenen Fahrzeugs genauer abschätzen lässt oder die verbleibende Anzahl der Startvorgänge eines Verbrennungsmotors genauer abgeschätzt werden kann.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung, solange diese unter den von den Ansprüchen definierten Umfang fallen. Insbesondere wird dabei der Fachmann auch Einzelaspekte als Verbesserungen oder Ergänzungen zu der jeweiligen Grundform der vorliegenden Erfindung hinzufügen.

Kurze Beschreibung der Zeichnungen

Im folgenden Abschnitt wird die Erfindung anhand von Ausführungsbeispielen, aus denen sich weitere erfinderische Merkmale ergeben können, auf die die Erfindung aber in ihrem Umfang nicht beschränkt ist, erläutert. Die Ausführungsbeispiele sind in den Zeichnungen dargestellt.

Es zeigen:

Fig. 1    ein schematisches Ablaufdiagramm eines erfindungsgemäßen Verfahrens zur Bestimmung eines Ladezustands eines elektrischen Energiespeichers;

Fig. 2    ein schematisches Ablaufdiagramm von Verfahrensschritten zur Bestimmung eines maximalen Ladezustands $SOC_{z_{max}}$ des elektrischen Energiespeichers basierend auf einer maximalen Leerlaufspannung $OCV_{max}^{f}$ und

Fig. 3    ein schematisches Ablaufdiagramm von Verfahrensschritten zur Bestimmung eines minimalen Ladezustands $SOC_{z_{min}}$ des elektrischen Energiespeichers basierend auf einer minimalen Leerlaufspannung $OCV_{min}^{f}$.

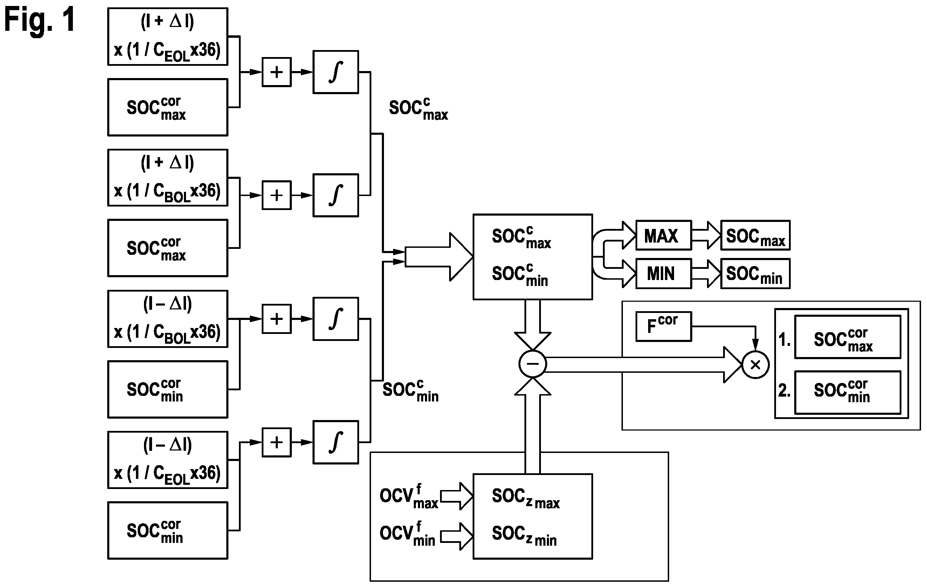

Fig. 1 zeigt ein schematisches Ablaufdiagramm des erfindungsgemäßen Verfahrens zur Bestimmung eines Ladezustands eines elektrischen Energiespeichers, der eine Mehrzahl von elektrischen Energiespeicherzellen und zumindest einen Sensor, insbesondere einen Stromsensor, einen Spannungssensor und einen Temperatursensor, aufweist.

Vorzugsweise sind die elektrischen Energiespeicherzellen in Reihe geschaltet angeordnet, wobei jede elektrische Energiespeicherzelle einen eigenen Spannungssensor aufweist und der elektrische Energiespeicher einen einzigen Stromsensor und Temperatursensor aufweist.

Alternativ können auch mehrere Temperatursensoren in dem elektrischen Energiespeicher angeordnet sein und/oder jede elektrische Energiespeicherzelle beziehungsweise Teilmengen der elektrischen Energiespeicherzellen können jeweils einen Stromsensor und/oder einen Temperatursensor aufweisen.

In einem ersten Verfahrensschritt des Verfahrens werden ein Strom I durch die elektrischen Energiespeicherzellen, eine Temperatur T, eine Strommessungenauigkeit $\Delta I$, eine Zellspannung $U^C$ jeder elektrischen Energiespeicherzelle, eine Zellspannungsmessungenauigkeit $\Delta U^C$, eine Kapazität jeder elektrischen Energiespeicherzelle zu Beginn ihrer Lebensdauer $C_{BOL}$ und eine Kapazität jeder elektrischen Energiespeicherzelle am Ende ihrer Lebensdauer $C_{EOL}$ als Betriebsparameter des elektrischen Energiespeichers bestimmt.

Dabei werden die oben genannten Parameter teilweise mittels Sensoren gemessen, zum Beispiel die Temperatur und/oder der Strom I und/oder die Zellspannung $U^C$. Teilweise werden die oben genannten Parameter aus einem Speichermittel des elektrischen Energiespeichers und/oder aus einer Tabelle und/oder einem Datenblatt der elektrischen Energiespeicherzellen abgelesen, zum Beispiel die Strommessungenauigkeit $\Delta I$, die Zellspannungsmessungenauigkeit $\Delta U^C$, die Kapazität jeder elektrischen Energiespeicherzelle zu Beginn ihrer Lebensdauer $C_{BOL}$ und die Kapazität jeder elektrischen Energiespeicherzelle am Ende ihrer Lebensdauer $C_{EOL}$.

In einem zweiten Verfahrensschritt wird zur Bestimmung eines maximalen Ladezustands jeder elektrischen Energiespeicherzelle $SOC_{max}^{C}$ die Summe aus Strommessungenauigkeit $\Delta I$ und Strom I mit der reziproken Kapazität jeder elektrischen Energiespeicherzelle zu Beginn ihrer Lebensdauer $C_{BOL}$ multipliziert und dazu ein Korrekturwert für den maximalen Ladezustand $SOC_{max}^{cor}$ addiert. Diese Summe wird für jede elektrische Energiespeicherzelle über die Zeit integriert. Zusätzlich wird die Summe aus Strommessungenauigkeit $\Delta I$ und Strom I mit der reziproken Kapazität jeder elektrischen Energiespeicherzelle am Ende ihrer Lebensdauer $C_{EOL}$ multipliziert und dazu der Korrekturwert für den maximalen Ladezustand $SOC_{max}^{cor}$ addiert. Diese Summe wird ebenfalls für jede elektrische Energiespeicherzelle über die Zeit integriert. Dadurch erhält man für jede elektrische Energiespeicherzelle zwei Werte für den maximalen Ladezustand $SOC_{max}^{C}$. Der maximale Ladezustand $SOC_{max}$ des gesamten elektrischen Energiespeichers entspricht dem Maximum aller maximalen Ladezustände $SOC_{max}^{C}$ der elektrischen Energiespeicherzellen.

Weiterhin wird zur Bestimmung eines minimalen Ladezustands jeder elektrischen Energiespeicherzelle $SOC_{min}^{C}$ die Differenz aus Strom I und Strommessungenauigkeit $\Delta I$ mit der reziproken Kapazität jeder elektrischen Energiespeicherzelle zu Beginn ihrer Lebensdauer $C_{BOL}$ multipliziert und dazu ein Korrekturwert für den minimalen Ladezustand $SOC_{min}^{cor}$ addiert. Diese Summe wird für jede elektrische Energiespeicherzelle über die Zeit integriert. Zusätzlich wird die Differenz aus Strom I und Strommessungenauigkeit $\Delta I$ mit der reziproken Kapazität jeder elektrischen Energiespeicherzelle am Ende ihrer Lebensdauer $C_{EOL}$ multipliziert und dazu der Korrekturwert für den minimalen Ladezustand $SOC_{min}^{cor}$ addiert. Diese Summe wird für jede elektrische Energiespeicherzelle über die Zeit integriert. Dadurch erhält man für jede elektrische Energiespeicherzelle zwei Werte für den minimalen Ladezustand $SOC_{min}^{C}$. Der minimale Ladezustand $SOC_{min}$ des gesamten elektrischen Energiespeichers entspricht dem Minimum aller minimalen Ladezustände $SOC_{min}^{C}$ der elektrischen Energiespeicherzellen.

In einem dritten Verfahrensschritt wird der maximale Ladezustand $SOC_{zmax}$ auf Basis der gefilterten maximalen Leerlaufspannung $OCV_{max}^{f}$ der elektrischen Energiespeicherzellen bestimmt, insbesondere nachdem der elektrische Energiespeicher abgeschaltet wurde.

Weiterhin wird der minimale Ladezustand $SOC_{zmin}$ auf Basis der gefilterten minimalen Leerlaufspannung $OCV_{min}^{f}$ der elektrischen Energiespeicherzellen bestimmt.

In einem vierten Verfahrensschritt wird zur Bestimmung beziehungsweise Korrektur des Korrekturwerts für den maximalen Ladezustand $SOC_{max}^{cor}$ die Differenz aus den maximalen Ladezuständen $SOC_{max}^{C}$ der elektrischen Energiespeicherzellen und dem maximalen Ladezustand $SOC_{zmax}$ auf Basis der gefilterten maximalen Leerlaufspannung $OCV_{max}^{f}$ der elektrischen Energiespeicherzellen gebildet und diese Differenz jeweils mit einem Korrekturfaktor $F^{cor}$ multipliziert.

Zur Bestimmung beziehungsweise Korrektur des Korrekturwerts für den minimalen Ladezustand $SOC_{min}^{cor}$ wird die Differenz aus den minimalen Ladezuständen $SOC_{min}^{C}$ der elektrischen Energiespeicherzellen und dem minimalen Ladezustand $SOC_{zmin}$ auf Basis der gefilterten minimalen Leerlaufspannung $OCV_{min}^{f}$ des elektrischen Energiespeichers gebildet und diese Differenz jeweils mit einem Korrekturfaktor $F^{cor}$ multipliziert.

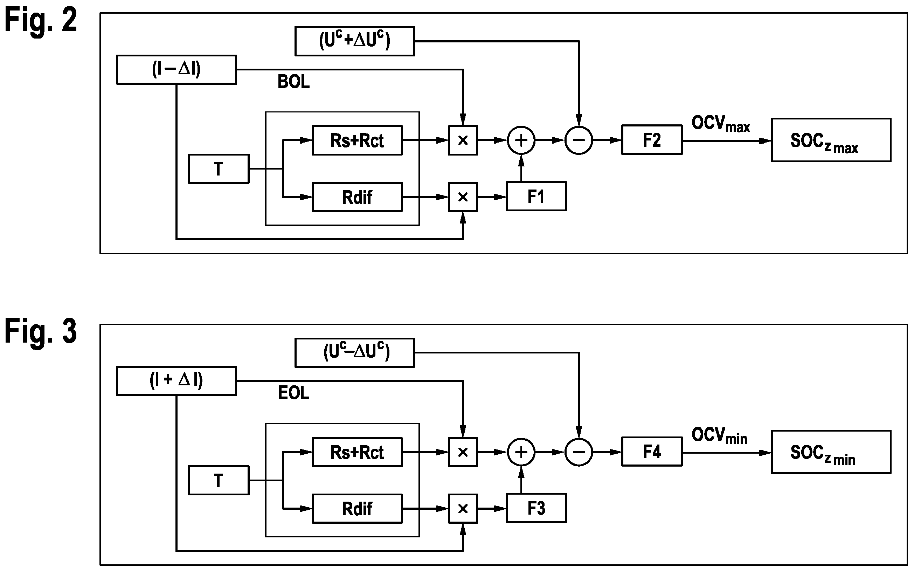

In Fig. 2 sind Verfahrensschritte zur Bestimmung des maximalen Ladezustands $SOC_{zmax}$ auf Basis der gefilterten maximalen Leerlaufspannung $OCV_{max}^{f}$ der elektrischen Energiespeicherzellen dargestellt. Vorzugsweise wird der maximale Ladezustand $SOC_{zmax}$ auf Basis der gefilterten maximalen Leerlaufspannung $OCV_{max}^{f}$ der elektrischen Energiespeicherzellen dann bestimmt, wenn der elektrische Energiespeicher nicht in Betrieb ist.

Zur Bestimmung der maximalen Leerlaufspannung $OCV_{max}^{f}$ der elektrischen Energiespeicherzellen wird die Differenz aus dem Strom I und der Strommessungenauigkeit $\Delta I$ gebildet. Basierend auf der Temperatur T des elektrischen Energiespeichers werden ein ohmscher Widerstand Rs, ein Ladetransferwiderstand Rct und ein Diffusionswiderstand Rdif am Beginn der Lebensdauer der elektrischen Energiespeicherzelle bestimmt, insbesondere aus einer Tabelle und/oder einem Datenblatt der elektrischen Energiespeicherzellen abgelesen.

Ein erstes Produkt aus der Summe aus dem ohmschen Widerstand Rs und dem Ladetransferwiderstand Rct und der Differenz aus dem Strom I und der Strommessungenauigkeit $\Delta I$ wird gebildet. Der Diffusionswiderstand Rdif wird ebenfalls mit der Differenz aus dem Strom I und der Strommessungenauigkeit $\Delta I$ multipliziert und anschließend von einem ersten Tiefpassfilter F1 gefiltert und zu dem ersten Produkt addiert. Diese Summe wird für jede elektrische Energiespeicherzelle mit einer Summe aus der Zellspannung $U^{C}$ und der Zellspannungsmessungenauigkeit $\Delta U^{C}$ multipliziert und daraus mittels eines zweiten Tiefpassfilters F2 die gefilterte maximale Leerlaufspannung $OCV_{max}^{f}$ der elektrischen Energiespeicherzellen bestimmt. Mithilfe einer Tabelle wird daraus der maximale Ladezustand $SOC_{zmax}$

auf Basis der gefilterten maximalen Leerlaufspannung $OCV_{max}^f$ der elektrischen Energiespeicherzellen bestimmt als Maximum aller Ladezustandskurven.

In Fig. 3 sind Verfahrensschritte zur Bestimmung des minimalen Ladezustands $SOC_{Zmin}$ auf Basis der gefilterten minimalen Leerlaufspannung $OCV_{max}^f$ der elektrischen Energiespeicherzellen dargestellt. Vorzugsweise wird der minimale Ladezustand $SOC_{Zmin}$ auf Basis der gefilterten minimalen Leerlaufspannung $OCV_{min}^f$ der elektrischen Energiespeicherzellen dann bestimmt, wenn der elektrische Energiespeicher nicht in Betrieb ist.

Zur Bestimmung der minimalen Leerlaufspannung $OCV_{max}^f$ der elektrischen Energiespeicherzellen wird die Summe aus dem Strom I und der Strommessungenauigkeit ΔI gebildet. Basierend auf der Temperatur T des elektrischen Energiespeichers werden ein ohmscher Widerstand Rs, ein Ladetransferwiderstand Rct und ein Diffusionswiderstand Rdif am Ende der Lebensdauer der elektrischen Energiespeicherzelle bestimmt, insbesondere aus einer Tabelle und/oder einem Datenblatt abgelesen.

Ein zweites Produkt aus der Summe aus dem ohmschen Widerstand Rs und dem Ladetransferwiderstand Rct und der Summe aus dem Strom I und der Strommessungenauigkeit ΔI wird gebildet. Der Diffusionswiderstand Rdif wird ebenfalls mit der Summe aus dem Strom I und der Strommessungenauigkeit ΔI multipliziert und anschließend von einem dritten Tiefpassfilter F3 gefiltert und zu dem zweiten Produkt addiert. Diese Summe wird für jede elektrische Energiespeicherzelle mit einer Differenz aus der Zellspannung $U^C$ und der Zellspannungsmessungenauigkeit $\Delta U^C$ multipliziert und daraus mittels eines vierten Tiefpassfilters F4 die gefilterte minimale Leerlaufspannung $OCV_{min}^f$ der elektrischen Energiespeicherzellen bestimmt. Mithilfe einer Tabelle wird daraus der minimale Ladezustand $SOC_{Zmin}$ auf Basis der gefilterten minimalen Leerlaufspannung $OCV_{min}^f$ der elektrischen Energiespeicherzellen bestimmt als Minimum aller Ladezustandskurven.

Unter einem elektrischen Energiespeicher wird hierbei ein wiederaufladbarer Energiespeicher verstanden, insbesondere aufweisend eine elektrochemische Energiespeicherzelle und/oder ein Energiespeichermodul aufweisend zumindest eine elektrochemische Energiespeicherzelle und/oder ein Energiespeicherpack aufweisend zumindest ein Energiespeichermodul. Die Energiespeicherzelle ist als lithiumbasierte Batteriezelle, insbesondere Lithium-Ionen-Batteriezelle, ausführbar. Alternativ ist die Energiespeicherzelle als Lithium-Polymer-Batteriezelle oder Nickel-Metallhydrid-Batteriezelle oder Blei-Säure-Batteriezelle oder Lithium-Luft-Batteriezelle oder Lithium-Schwefel-Batteriezelle ausgeführt.

Unter einem Fahrzeug wird hierbei ein Landfahrzeug, zum Beispiel ein Personenkraftwagen oder ein Lastkraftwagen, oder ein Luftfahrzeug oder ein Wasserfahrzeug verstanden, insbesondere ein zumindest teilweise elektrisch angetriebenes Fahrzeug. Das Fahrzeug ist beispielsweise ein batterieelektrisch angetriebenes Fahrzeug, das einen rein elektrischen Antrieb aufweist, oder ein Hybridfahrzeug, das einen elektrischen Antrieb und einen Verbrennungsmotor aufweist.

## Patentansprüche

1. Verfahren zur Bestimmung eines Ladezustands eines elektrischen Energiespeichers, aufweisend elektrische Energiespeicherzellen und zumindest einen Sensor,

wobei in einem ersten Verfahrensschritt Betriebsparameter des elektrischen Energiespeichers bestimmt werden,
wobei in einem zweiten Verfahrensschritt zumindest ein maximaler Ladezustand und zumindest ein minimaler Ladezustand für jede elektrische Energiespeicherzelle als zeitliches Integral bestimmt werden basierend auf einem Strom (I), einer Strommessungenauigkeit (ΔI), zumindest einer Kapazität, wobei ein maximaler Ladezustand ($SOC_{max}$) des elektrischen Energiespeichers das Maximum von maximalen Ladezuständen ($SOC_{max}^C$) aller elektrischen Energiespeicherzellen ist und ein minimaler Ladezustand ($SOC_{min}$) des elektrischen Energiespeichers das Minimum von minimalen Ladezuständen ($SOC_{min}^C$) aller elektrischen Energiespeicherzellen ist, **dadurch gekennzeichnet, dass** in dem zweitem Verfahrensschritt die Bestimmung des zumindest einen maximalen Ladezustands und des zumindest einen minimalen Ladezustands für jede elektrische Energiespeicherzelle weiterhin basiert auf einem Korrekturwert für den minimalen Ladezustand ($SOC_{min}^{cor}$) und einem Korrekturwert für den maximalen Ladezustand ($SOC_{max}^{cor}$) der elektrischen Energiespeicherzellen,
wobei der Korrekturwert für den minimalen Ladezustand ($SOC_{min}^{cor}$) mittels eines minimalen Ladezustands ($SOC_{Zmin}$) auf Basis einer gefilterten minimalen Leerlaufspannung ($OCV_{min}^f$) des elektrischen Energiespeichers bestimmt wird, wobei der Korrekturwert für den maximalen Ladezustand ($SOC_{max}^{cor}$) mittels eines maximalen Ladezustands ($SOC_{Zmax}$) auf Basis einer gefilterten maximalen Leerlaufspannung (

$OCV_{\min}^{f}$ ) des elektrischen Energiespeichers bestimmt wird.

2. Verfahren nach Anspruch 1,
**dadurch gekennzeichnet, dass**

im zweiten Verfahrensschritt für jede elektrische Energiespeicherzelle jeweils zwei minimale Ladezustände ( $SOC_{\min}^{C}$ ) und zwei maximale Ladezustände ( $SOC_{\max}^{C}$ ) bestimmt werden, insbesondere wobei zur Bestimmung von ersten maximalen Ladezuständen ( $SOC_{\max}^{C}$ ) eine Kapazität ($C_{BOL}$) am Anfang der Lebensdauer der elektrischen Energiespeicherzellen verwendet wird und zur Bestimmung von zweiten maximalen Ladezuständen ( $SOC_{\max}^{C}$ ) eine Kapazität ($C_{EOL}$) am Ende der Lebensdauer der elektrischen Energiespeicherzellen verwendet wird,
und wobei zur Bestimmung von ersten minimalen Ladezuständen ( $SOC_{\min}^{C}$ )die Kapazität ($C_{BOL}$) am Anfang der Lebensdauer der elektrischen Energiespeicherzellen verwendet wird und zur Bestimmung von zweiten minimalen Ladezuständen ( $SOC_{\min}^{C}$ ) die Kapazität ($C_{EOL}$) am Ende der Lebensdauer der elektrischen Energiespeicherzellen verwendet wird.

3. Verfahren nach Anspruch 2,
**dadurch gekennzeichnet, dass**
im zweiten Verfahrensschritt zur Bestimmung der maximalen Ladezustände jeder elektrischen Energiespeicherzelle ( $SOC_{\max}^{C}$ ) die Summe aus Strommessungenauigkeit ($\Delta I$) und Strom ($I$) mit der reziproken Kapazität jeder elektrischen Energiespeicherzelle zu Beginn ihrer Lebensdauer ($C_{BOL}$) multipliziert wird beziehungsweise mit der reziproken Kapazität jeder elektrischen Energiespeicherzelle am Ende ihrer Lebensdauer ($C_{EOL}$) multipliziert wird und dazu jeweils der Korrekturwert für den maximalen Ladezustand ( $SOC_{\max}^{cor}$ ) addiert wird, wobei zur Bestimmung der minimalen Ladezustände jeder elektrischen Energiespeicherzelle ( $SOC_{\min}^{C}$ ) die Differenz aus Strom ($I$) und Strommessungenauigkeit ($\Delta I$) mit der reziproken Kapazität jeder elektrischen Energiespeicherzelle zu Beginn ihrer Lebensdauer ($C_{BOL}$) multipliziert beziehungsweise mit der reziproken Kapazität jeder elektrischen Energiespeicherzelle am Ende ihrer Lebensdauer ($C_{EOL}$) multipliziert wird und dazu jeweils der Korrekturwert für den minimalen Ladezustand ( $SOC_{\min}^{cor}$ ) addiert wird.

4. Verfahren nach einem der vorhergehenden Ansprüche,
**dadurch gekennzeichnet, dass**

in einem dritten Verfahrensschritt der maximale Ladezustand ($SOC_{z_{max}}$) auf Basis der gefilterten maximalen Leerlaufspannung ( $OCV_{\max}^{f}$ ) der elektrischen Energiespeicherzellen bestimmt wird und der minimale Ladezustand ($SOC_{z_{min}}$) auf Basis der gefilterten minimalen Leerlaufspannung ( $OCV_{\min}^{f}$ ) der elektrischen Energiespeicherzellen bestimmt wird,
wobei in einem vierten Verfahrensschritt zur Bestimmung beziehungsweise Korrektur des Korrekturwerts für den maximalen Ladezustand ( $SOC_{\max}^{cor}$ ) die Differenz aus den maximalen Ladezuständen ( $SOC_{\max}^{C}$ ) der elektrischen Energiespeicherzellen und dem maximalen Ladezustand ($SOC_{z_{max}}$) auf Basis der gefilterten maximalen Leerlaufspannung ( $OCV_{\max}^{f}$ ) der elektrischen Energiespeicherzellen gebildet wird und wobei zur Bestimmung beziehungsweise Korrektur des Korrekturwerts für den minimalen Ladezustand ( $SOC_{\min}^{cor}$ ) die Differenz aus den minimalen Ladezuständen ( $SOC_{\min}^{C}$ ) der elektrischen Energiespeicherzellen und dem minimalen Ladezustand ($SOC_{z_{min}}$) auf Basis der gefilterten minimalen Leerlaufspannung ( $OCV_{\min}^{f}$ ) des elektrischen Energiespeichers gebildet wird.

5. Verfahren nach Anspruch 4,
**dadurch gekennzeichnet, dass**
im vierten Verfahrensschritt zur Bestimmung beziehungsweise Korrektur des jeweiligen Korrekturwerts die Differenz aus den maximalen Ladezuständen ( $SOC_{\max}^{C}$ ) der elektrischen Energiespeicherzellen und dem maximalen Ladezustand ($SOC_{z_{max}}$) auf Basis der gefilterten maximalen Leerlaufspannung ( $OCV_{\max}^{f}$ ) der elektrischen Energiespeicherzellen jeweils mit einem Korrekturfaktor ($F^{cor}$) multipliziert wird und die Differenz aus den minimalen Ladezuständen ( $SOC_{\min}^{C}$ ) der elektrischen Energiespeicherzellen und dem minimalen Ladezustand ($SOC_{z_{min}}$) auf Basis der gefilterten minimalen Leerlaufspannung ( $OCV_{\min}^{f}$ ) des elektrischen Energiespeichers jeweils mit einem Korrekturfaktor ($F^{cor}$) multipliziert wird.

**6.** Verfahren nach einem der Ansprüche 4 oder 5,
**dadurch gekennzeichnet, dass**

zur Bestimmung der maximalen Leerlaufspannung ( $OCV_{max}^{f}$ ) der elektrischen Energiespeicherzellen eine Differenz aus dem Strom (I) und der Strommessungenauigkeit (ΔI) gebildet wird und basierend auf der Temperatur (T) des elektrischen Energiespeichers ein ohmscher Widerstand (Rs), ein Ladetransferwiderstand (Rct) und ein Diffusionswiderstand (Rdif) zu Beginn der Lebensdauer der elektrischen Energiespeicherzelle bestimmt wird,
wobei ein erstes Produkt aus der Summe aus dem ohmschen Widerstand (Rs) und dem Ladetransferwiderstand (Rct) und der Differenz aus dem Strom (I) und der Strommessungenauigkeit (ΔI) gebildet wird,
wobei der Diffusionswiderstand (Rdif) mit der Differenz aus dem Strom (I) und der Strommessungenauigkeit (ΔI) multipliziert und anschließend von einem ersten Tiefpassfilter (F1) gefiltert und zu dem ersten Produkt addiert wird,
wobei diese Summe für jede elektrische Energiespeicherzelle mit einer Summe aus der Zellspannung (U$^C$) und der Zellspannungsmessungenauigkeit (ΔU$^C$) jeder elektrischen Energiespeicherzelle multipliziert wird und daraus mittels eines zweiten Tiefpassfilters (F2) die gefilterte maximale Leerlaufspannung ( $OCV_{max}^{f}$ ) der elektrischen Energiespeicherzellen bestimmt wird.

**7.** Verfahren nach einem der Ansprüche 4 bis 6,
**dadurch gekennzeichnet, dass**

zur Bestimmung der minimalen Leerlaufspannung ( $OCV_{min}^{f}$ ) der elektrischen Energiespeicherzellen eine Summe aus dem Strom (I) und der Strommessungenauigkeit (ΔI) gebildet wird und basierend auf der Temperatur (T) des elektrischen Energiespeichers ein ohmscher Widerstand (Rs), ein Ladetransferwiderstand (Rct) und ein Diffusionswiderstand (Rdif) am Ende der Lebensdauer der elektrischen Energiespeicherzelle bestimmt wird,
wobei ein zweites Produkt aus der Summe aus dem ohmschen Widerstand (Rs) und dem Ladetransferwiderstand (Rct) und der Summe aus dem Strom (I) und der Strommessungenauigkeit (ΔI) gebildet wird,
wobei der Diffusionswiderstand (Rdif) mit der Summe aus dem Strom (I) und der Strommessungenauigkeit (ΔI) multipliziert und anschließend von einem dritten Tiefpassfilter (F3) gefiltert und zu dem zweiten Produkt addiert wird,
wobei diese Summe für jede elektrische Energiespeicherzelle mit einer Differenz aus der Zellspannung (U$^C$) und der Zellspannungsmessungenauigkeit (ΔU$^C$) jeder elektrischen Energiespeicherzelle multipliziert wird und daraus mittels eines vierten Tiefpassfilters (F4) die gefilterte maximale Leerlaufspannung ( $OCV_{max}^{f}$ ) der elektrischen Energiespeicherzellen bestimmt wird.

**8.** Verfahren nach einem der Ansprüche 6 oder 7,
**dadurch gekennzeichnet, dass**

der maximale Ladezustand (SOC$_{z_{max}}$) auf Basis der gefilterten maximalen Leerlaufspannung ( $OCV_{max}^{f}$ ) der elektrischen Energiespeicherzellen das Maximum aller Ladezustandskurven der elektrischen Energiespeicherzellen ist, und/oder dass
der minimale Ladezustand (SOC$_{z_{min}}$) auf Basis der gefilterten minimalen Leerlaufspannung ( $OCV_{min}^{f}$ ) der elektrischen Energiespeicherzellen das Minimum aller Ladezustandskurven der elektrischen Energiespeicherzellen ist.

**9.** Verfahren nach einem der vorhergehenden Ansprüche,
**dadurch gekennzeichnet, dass**

der erste und/oder zweite Verfahrensschritt während des Betriebs des elektrischen Energiespeichers ausgeführt wird,
und/oder dass
der dritte und/oder vierte Verfahrensschritt ausgeführt wird, wenn der elektrische Energiespeicher nicht in Betrieb ist.

**10.** Elektrischer Energiespeicher aufweisend elektrische Energiespeicherzellen und zumindest einen Sensor,
**dadurch gekennzeichnet, dass**
der elektrische Energiespeicher ausgebildet ist, den Ladezustand des elektrischen Energiespeichers mittels eines Verfahrens nach einem der vorhergehenden Ansprüche zu bestimmen.

**11.** Vorrichtung, insbesondere Fahrzeug, aufweisend einen elektrischen Energiespeicher nach Anspruch 10.

**Claims**

**1.** Method for determining a state of charge of an electrical energy storage device, comprising electrical energy storage cells and at least one sensor, wherein, in a first method step, operating parameters of the electrical energy storage device are determined,

wherein, in a second method step, at least one maximum state of charge and at least one minimum state of charge for each electrical energy storage cell are determined as a temporal integral based on a current (I), a current measurement inaccuracy ($\Delta I$), at least one capacitance, wherein a maximum state of charge ($SOC_{max}$) of the electrical energy storage device is the maximum of maximum states of charge ( $SOC_{max}^C$ ) of all electrical energy storage cells and a minimum state of charge ($SOC_{min}$) of the electrical energy storage device is the minimum of minimum states of charge ( $SOC_{min}^C$ ) of all electrical energy storage cells, **characterized in that**, in the second method step, the determination of the at least one maximum state of charge and of the at least one minimum state of charge for each electrical energy storage cell is furthermore based on a correction value for the minimum state of charge ( $SOC_{min}^{cor}$ ) and a correction value for the maximum state of charge ( $SOC_{max}^{cor}$ ) of the electrical energy storage cells, wherein the correction value for the minimum state of charge ( $SOC_{min}^{cor}$ ) is determined by means of a minimum state of charge ($SOC_{Zmin}$) based on a filtered minimum open-circuit voltage ( $OCV_{min}^f$ ) of the electrical energy storage device, wherein the correction value for the maximum state of charge ( $SOC_{max}^{cor}$ ) is determined by means of a maximum state of charge ($SOC_{Zmax}$) based on a filtered maximum open-circuit voltage ( $OCV_{min}^f$ ) of the electrical energy storage device.

2. Method according to Claim 1, **characterized in that**,

in the second method step, two minimum states of charge ( $SOC_{min}^C$ ) and two maximum states of charge ( $SOC_{max}^C$ ) are determined for each electrical energy storage cell, in particular wherein a capacitance ($C_{BOL}$) at the beginning of the service life of the electrical energy storage cells is used for the determination of first maximum states of charge ( $SOC_{max}^C$ ) and a capacitance ($C_{EOL}$) at the end of the life of the electrical energy storage cells is used for the determination of second maximum states of charge ( $SOC_{max}^C$ ), and wherein the capacitance ($C_{BOL}$) at the beginning of the service life of the electrical energy storage cells is used for the determination of first minimum states of charge ( $SOC_{min}^C$ ) and the capacitance ($C_{EOL}$) at the end of the life of the electrical energy storage cells is used for the determination of second minimum states of charge ( $SOC_{min}^C$ ),

3. Method according to Claim 2, **characterized in that**,

in the second method step, to determine the maximum states of charge of each electrical energy storage cell ( $SOC_{max}^C$ ), the sum of the current measurement inaccuracy ($\Delta I$) and the current (I) is multiplied by the reciprocal capacitance of each electrical energy storage cell at the beginning of its service life ($C_{BOL}$) or is multiplied by the reciprocal capacitance of each electrical energy storage cell at the end of its life ($C_{EOL}$) and the correction value for the maximum state of charge is added thereto ( $SOC_{max}^{cor}$ ), wherein, to determine the minimum states of charge of each electrical energy storage cell ( $SOC_{min}^C$ ), the difference between the current (I) and the current measurement inaccuracy ($\Delta I$) is multiplied by the reciprocal capacitance of each electrical energy storage cell at the beginning of its service life ($C_{BOL}$) or is multiplied by the reciprocal capacitance of each electrical energy storage cell at the end of its life ($C_{EOL}$) and the correction value for the minimum state of charge is added thereto ( $SOC_{min}^{cor}$ ).

4. Method according to any one of the preceding claims, **characterized in that**,

in a third method step, the maximum state of charge ($SOC_{Zmax}$) is determined on the basis of the filtered maximum open-circuit voltage ( $OCV_{max}^f$ ) of the electrical energy storage cells and the minimum state of charge ($SOC_{zmin}$) is determined on the basis of the filtered minimum open-circuit voltage ( $OCV_{min}^f$ ) of the electrical energy storage cells, wherein, in a fourth method step, to determine or correct the correction value for the maximum state of charge ( $SOC_{max}^{cor}$ ), the difference between the maximum states of charge ( $SOC_{max}^{c}$ ) of the electrical energy storage cells and the maximum state of charge ($SOC_{Zmax}$) is formed on the basis of the filtered maximum open-circuit voltage ( $OCV_{max}^{f}$ ) of the electrical energy storage cells and wherein, to determine or correct the correction value for the minimum state of charge ( $SOC_{min}^{cor}$ ), the difference between the minimum states of charge ( $SOC_{min}^{c}$ ) of the electrical energy storage cells and the minimum state of charge ($SOC_{Zmin}$) is formed on the basis of the filtered minimum open-circuit voltage ( $OCV_{min}^{f}$ ) of the electrical energy storage device.

5. Method according to Claim 4,
   **characterized in that**,
   in the fourth method step, to determine or correct the respective correction value, the difference between the maximum states of charge ( $SOC_{max}^{c}$ ) of the electrical energy storage cells and the maximum state of charge ($SOC_{Zmax}$) on the basis of the filtered maximum open-circuit voltage ( $OCV_{max}^{f}$ ) of the electrical energy storage cells is multiplied by a correction factor ($F^{cor}$) and the difference between the minimum states of charge ( $SOC_{min}^{c}$ ) of the electrical energy storage cells and the minimum state of charge ($SOC_{Zmin}$) on the basis of the filtered minimum open-circuit voltage ( $OCV_{min}^{f}$ ) of the electrical energy storage device is multiplied by a correction factor ($F^{cor}$).

6. Method according to either of Claims 4 and 5,
   **characterized in that**,

   to determine the maximum open-circuit voltage ( $OCV_{max}^{f}$ ) of the electrical energy storage cells, a difference between the current (I) and the current measurement inaccuracy (ΔI) is formed and an ohmic resistance (Rs), a charge transfer resistor (Rct) and a diffusion resistor (Rdif) at the beginning of the service life of the electrical energy storage cell are determined based on the temperature (T) of the electrical energy storage device, wherein a first product is formed from the sum of the ohmic resistance (Rs) and the charge transfer resistance (Rct) and the difference between the current (I) and the current measurement inaccuracy (ΔI),
wherein the diffusion resistance (Rdif) is multiplied by the difference between the current (I) and the current measurement inaccuracy (ΔI) and then filtered by a first low-pass filter (F1) and added to the first product, wherein, for each electrical energy storage cell, this sum is multiplied by a sum of the cell voltage ($U^{C}$) and the cell voltage measurement accuracy ($ΔU^{C}$) of each electrical energy storage cell, and from this the filtered maximum open-circuit voltage ( $OCV_{max}^{f}$ ) of the electrical energy storage cells is determined by means of a second low-pass filter (F2).

7. Method according to one of Claims 4 to 6,
   **characterized in that**,

   to determine the minimum open-circuit voltage ( $OCV_{min}^{f}$ ) of the electrical energy storage cells, a sum of the current (I) and the current measurement inaccuracy (ΔI) is formed and an ohmic resistance (Rs), a charge transfer resistor (Rct) and a diffusion resistor (Rdif) at the end of the service life of the electrical energy storage cell are determined based on the temperature (T) of the electrical energy storage device, wherein a second product is formed from the sum of the ohmic resistance (Rs) and the charge transfer resistance (Rct) and the sum between the current (I) and the current measurement inaccuracy (ΔI), wherein the diffusion resistance (Rdif) is multiplied by the sum of the current (I) and the current measurement inaccuracy (ΔI) and then filtered by a third low-pass filter (F3) and added to the second product, wherein, for each electrical energy storage cell, this sum is multiplied by a difference between the cell voltage ($U^{C}$) and the cell voltage measurement inaccuracy ($ΔU^{C}$) of each electrical energy storage cell, and from this the filtered maximum open-circuit voltage ( $OCV_{max}^{f}$ ) of the electrical energy storage cells is determined by means of a fourth low-pass filter (F4).

8. Method according to either of Claims 6 and 7,
   **characterized in that**,

   the maximum state of charge ($SOC_{Zmax}$) based on the filtered maximum open-circuit voltage ( $OCV_{max}^{f}$ ) of the electrical energy storage cells is the maximum of all state of charge curves of the electrical energy storage cells,
   and/or **in that**

the minimum state of charge (SOC$_{Zmin}$) based on the filtered minimum open-circuit voltage ( $OCV_{min}^{f}$ ) of the electrical energy storage cells is the minimum of all state of charge curves of the electrical energy storage cells.

9. Method according to any one of the preceding claims, **characterized in that**,

the first and/or second method step is carried out during operation of the electrical energy storage device, and/or **in that** the third and/or fourth method step is carried out when the electrical energy storage device is not in operation.

10. Electrical energy storage device having electrical energy storage cells and at least one sensor, **characterized in that**, the electrical energy storage device is designed to determine the state of charge of the electrical energy storage device by means of a method according to any one of the preceding claims.

11. Device, in particular vehicle, having an electrical energy storage device according to Claim 10.

**Revendications**

1. Procédé destiné à la détermination de l'état de charge d'un accumulateur d'énergie électrique, comportant des cellules d'accumulateur d'énergie électrique et au moins un capteur,

dans lequel, dans une première étape de procédé, des paramètres de fonctionnement de l'accumulateur d'énergie électrique sont déterminés,
dans lequel, dans une deuxième étape de procédé, au moins un état de charge maximal et au moins un état de charge minimal pour chaque cellule d'accumulateur d'énergie électrique sont déterminés sous forme d'intégrale temporelle sur la base d'un courant (I), d'une imprécision de mesure de courant (ΔI), d'au moins une capacité, un état de charge maximal (SOC$_{max}$) de l'accumulateur d'énergie électrique étant le maximum des états de charge maximaux ( $SOC_{max}^{C}$ ) de toutes les cellules d'accumulateur d'énergie électrique et un état de charge minimal (SOC$_{min}$) de l'accumulateur d'énergie électrique étant le minimum des états de charge minimaux ( $SOC_{min}^{C}$ ) de toutes les cellules d'accumulateur d'énergie électrique, **caractérisé en ce que**, dans la deuxième étape de procédé, la détermination de l'au moins un état de charge maximal et de l'au moins un état de charge minimal pour chaque cellule d'accumulateur d'énergie électrique est en outre basée sur une valeur de correction pour l'état de charge minimal ( $SOC_{min}^{cor}$ )et une valeur de correction pour l'état de charge maximal ( $SOC_{max}^{cor}$ ) des cellules d'accumulateur d'énergie électrique,
la valeur de correction pour l'état de charge minimal ( $SOC_{min}^{cor}$ )étant déterminée au moyen d'un état de charge minimal (SOC$_{Zmin}$) sur la base d'une tension de circuit ouvert minimale filtrée ( $OCV_{min}^{f}$ ) de l'accumulateur d'énergie électrique,
la valeur de correction pour l'état de charge maximal ( $SOC_{max}^{cor}$ ) étant déterminée au moyen d'un état de charge maximal (SOC$_{Zmax}$) sur la base d'une tension de circuit ouvert maximale filtrée ( $OCV_{min}^{f}$ ) de l'accumulateur d'énergie électrique.

2. Procédé selon la revendication 1, **caractérisé en ce que**

dans la deuxième étape de procédé, deux états de charge minimaux ( $SOC_{min}^{C}$ )et deux états de charge maximaux ( $SOC_{max}^{C}$ ) sont déterminés respectivement pour chaque cellule d'accumulateur d'énergie électrique,
en particulier, une capacité (C$_{BOL}$) au début de la durée de vie des cellules d'accumulateur d'énergie électrique étant utilisée pour la détermination de premiers états de charge maximaux ( $SOC_{max}^{C}$ ) et une capacité (C$_{EOL}$) à la fin de la durée de vie des cellules d'accumulateur d'énergie électrique étant utilisée pour la détermination de seconds états de charge maximaux ( $SOC_{max}^{C}$ ), et la capacité (C$_{BOL}$) au début de la durée de vie des cellules d'accumulateur d'énergie électrique étant utilisée pour la détermination de premiers états de charge minimaux ( $SOC_{min}^{C}$ ) et la capacité (C$_{EOL}$) à la fin de la durée de vie des cellules d'accumulateur d'énergie électrique étant utilisée pour la détermination de seconds états de charge minimaux ( $SOC_{min}^{C}$ ).

**3.** Procédé selon la revendication 2, **caractérisé en ce que**

dans la deuxième étape de procédé, pour la détermination des états de charge maximaux de chaque cellule d'accumulateur d'énergie électrique ( $SOC_{max}^{C}$ ), la somme de l'imprécision de mesure de courant (ΔI) et du courant (I) est multipliée par la capacité réciproque de chaque cellule d'accumulateur d'énergie électrique au début de sa durée de vie ($C_{BOL}$) ou est multipliée par la capacité réciproque de chaque cellule d'accumulateur d'énergie électrique à la fin de sa durée de vie ($C_{EOL}$) et la valeur de correction pour l'état de charge maximal ( $SOC_{max}^{cor}$ ) y est respectivement ajoutée,

dans lequel, pour la détermination des états de charge minimaux de chaque cellule d'accumulateur d'énergie électrique ( $SOC_{min}^{C}$ ) la différence entre le courant (I) et l'imprécision de mesure de courant (ΔI) est multipliée par la capacité réciproque de chaque cellule d'accumulateur d'énergie électrique au début de sa durée de vie ($C_{BOL}$) ou est multipliée par la capacité réciproque de chaque cellule d'accumulateur d'énergie électrique à la fin de sa durée de vie ($C_{EOL}$), et la valeur de correction pour l'état de charge minimal ( $SOC_{min}^{cor}$ ) y est respectivement ajoutée.

**4.** Procédé selon l'une des revendications précédentes, **caractérisé en ce que**

dans une troisième étape de procédé, l'état de charge maximal ($SOC_{Zmax}$) est déterminé sur la base de la tension de circuit ouvert maximale filtrée ( $OCV_{max}^{f}$ ) des cellules d'accumulateur d'énergie électrique et l'état de charge minimal ($SOC_{Zmin}$) est déterminé sur la base de la tension de circuit ouvert minimale filtrée ( $OCV_{min}^{f}$ ) des cellules d'accumulateur d'énergie électrique,

dans lequel, dans une quatrième étape de procédé, pour la détermination ou, respectivement, la correction de la valeur de correction pour l'état de charge maximal ( $SOC_{max}^{cor}$ ), la différence entre les états de charge maximaux ( $SOC_{max}^{C}$ ) des cellules d'accumulateur d'énergie électrique et l'état de charge maximal ($SOC_{Zmax}$) est établie sur la base de la tension de circuit ouvert maximale filtrée ( $OCV_{max}^{f}$ ) des cellules d'accumulateur d'énergie électrique, et pour la détermination ou, respectivement, la correction de des cellules d'accumulateur d'énergie électrique, et pour la détermination ou, respectivement, la correction de la valeur de correction pour l'état de charge minimal ( $SOC_{min}^{cor}$ ), la différence entre les états de charge minimaux ( $SOC_{min}^{C}$ ) des cellules d'accumulateur d'énergie électrique et l'état de charge minimal ($SOC_{Zmin}$) est établie sur la base de la tension de circuit ouvert minimale filtrée ( $OCV_{min}^{f}$ ) de l'accumulateur d'énergie électrique.

**5.** Procédé selon la revendication 4, **caractérisé en ce que**

dans la quatrième étape de procédé, pour la détermination ou, respectivement, la correction de la valeur de correction respective, la différence entre les états de charge maximaux ( $SOC_{max}^{C}$ ) des cellules d'accumulateur d'énergie électrique et l'état de charge maximal ($SOC_{Zmax}$) sur la base de la tension de circuit ouvert maximale filtrée ( $OCV_{max}^{f}$ ) des cellules d'accumulateur d'énergie électrique est respectivement multipliée par un facteur de correction ($F^{cor}$) et la différence entre les états de charge minimaux ( $SOC_{min}^{C}$ ) des cellules d'accumulateur d'énergie électrique et l'état de charge minimal ($SOC_{Zmin}$) sur la base de la tension de circuit ouvert minimale filtrée ( $OCV_{min}^{f}$ ) de l'accumulateur d'énergie électrique est respectivement multipliée par un facteur de correction ($F^{cor}$).

**6.** Procédé selon l'une des revendications 4 ou 5, **caractérisé en ce que**

pour la détermination de la tension de circuit ouvert maximale ( $OCV_{max}^{f}$ ) des cellules d'accumulateur d'énergie électrique, une différence est établie entre le courant (I) et l'imprécision de mesure de courant (ΔI) et une résistance ohmique (Rs), une résistance de transfert de charge (Rct) et une résistance de diffusion (Rdif) au début de la durée de vie de la cellule d'accumulateur d'énergie électrique sont déterminées sur la base de la température (T) de l'accumulateur d'énergie électrique,

un premier produit étant établi à partir de la somme de la résistance ohmique (Rs) et de la résistance de transfert de charge (Rct) et de la différence entre le courant (I) et l'imprécision de mesure de courant (ΔI),

la résistance de diffusion (Rdif) étant multipliée par la différence entre le courant (I) et l'imprécision de mesure de courant (ΔI), puis filtrée par un premier filtre passe-bas (F1) et ajoutée au premier produit,

cette somme étant, pour chaque cellule d'accumulateur d'énergie électrique, multipliée par une somme de la tension de cellule ($U^C$) et de l'imprécision de mesure de tension de cellule ($\Delta U^C$) de chaque cellule d'accumulateur d'énergie électrique, et la tension de circuit ouvert maximale filtrée ( $OCV_{max}^f$ ) des cellules d'accumulateur d'énergie électrique étant déterminée à partir de celle-ci au moyen d'un deuxième filtre passe-bas (F2).

7. Procédé selon l'une des revendications 4 à 6, **caractérisé en ce que**

pour la détermination de la tension de circuit ouvert minimale ( $OCV_{min}^f$ ) des cellules d'accumulateur d'énergie électrique, une somme du courant (I) et de l'imprécision de mesure de courant ($\Delta$I) est établie, et une résistance ohmique (Rs), une résistance de transfert de charge (Rct) et une résistance de diffusion (Rdif) à la fin de la durée de vie de la cellule d'accumulateur d'énergie électrique sont déterminées sur la base de la température (T) de l'accumulateur d'énergie électrique,

un deuxième produit étant établi à partir de la somme de la résistance ohmique (Rs) et de la résistance de transfert de charge (Rct) et de la somme du courant (I) et de l'imprécision de mesure de courant ($\Delta$I),

la résistance de diffusion (Rdif) étant multipliée par la somme du courant (I) et de l'imprécision de mesure de courant ($\Delta$I), puis filtrée par un troisième filtre passe-bas (F3) et ajoutée au deuxième produit,

cette somme étant, pour chaque cellule d'accumulateur d'énergie électrique, multipliée par une différence entre la tension de cellule ($U^C$) et l'imprécision de mesure de tension de cellule ($\Delta U^C$) de chaque cellule d'accumulateur d'énergie électrique, et la tension de circuit ouvert maximale filtrée ( $OCV_{max}^f$ ) des cellules d'accumulateur d'énergie électrique étant déterminée à partir de celle-ci au moyen d'un quatrième filtre passe-bas (F4).

8. Procédé selon l'une des revendications 6 ou 7, **caractérisé en ce que**

l'état de charge maximal (SOC$_{zmax}$) est le maximum de toutes les courbes d'état de charge des cellules d'accumulateur d'énergie électrique sur la base de la tension maximale filtrée de circuit ouvert ( $OCV_{max}^f$ ) des cellules d'accumulateur d'énergie électrique, et/ou **en ce que** l'état de charge minimal (SOC$_{zmin}$) est le minimum de toutes les courbes d'état de charge des cellules d'accumulateur d'énergie électrique sur la base de la tension de circuit ouvert minimale filtrée ( $OCV_{min}^f$ ) des cellules d'accumulateur d'énergie électrique.

9. Procédé selon l'une des revendications précédentes, **caractérisé en ce que**

la première et/ou la deuxième étape de procédé sont effectuées pendant le fonctionnement de l'accumulateur d'énergie électrique, et/ou **en ce que** la troisième et/ou la quatrième étape de procédé sont effectuées lorsque l'accumulateur d'énergie électrique n'est pas en fonctionnement.

10. Accumulateur d'énergie électrique comportant des cellules d'accumulateur d'énergie électrique et au moins un capteur, **caractérisé en ce que** l'accumulateur d'énergie électrique est conçu pour déterminer l'état de charge de l'accumulateur d'énergie électrique au moyen d'un procédé selon l'une des revendications précédentes.

11. Dispositif, en particulier véhicule, comportant un accumulateur d'énergie électrique selon la revendication 10.

**Fig. 1**

$(I + \triangle I) \times (1 / C_{EOL} \times 36)$

$SOC_{max}^{cor}$

$+$   $\int$

$(I + \triangle I) \times (1 / C_{BOL} \times 36)$

$SOC_{max}^{cor}$

$+$   $\int$

$(I - \triangle I) \times (1 / C_{BOL} \times 36)$

$SOC_{min}^{cor}$

$+$   $\int$

$(I - \triangle I) \times (1 / C_{EOL} \times 36)$

$SOC_{min}^{cor}$

$+$   $\int$

$SOC_{max}^{c}$

$SOC_{min}^{c}$

$SOC_{max}^{c}$

$SOC_{min}^{c}$

MAX   $SOC_{max}$

MIN   $SOC_{min}$

$-$

$F^{cor}$

$\times$

1.   $SOC_{max}^{cor}$

2.   $SOC_{min}^{cor}$

$OCV_{max}^{f}$   $SOC_{z\,max}$

$OCV_{min}^{f}$   $SOC_{z\,min}$

EP 4 396 595 B1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20100321025 A1
- US 20070299620 A1
- US 20140333317 A1
- GB 2478557 A
- EP 2787361 A1
- US 2021190867 A1